# EUROPÄISCHE PATENTSCHRIFT

(11) **EP 1 224 689 B1**
(45) Veröffentlichungstag und Bekanntmachung des Hinweises auf die Patenterteilung: **13.12.2006**
(21) Anmeldenummer: 00983051.4
(22) Anmeldetag: 24.10.2000
(51) Int. Cl.: H01L 21/00

(54) **ANLAGE ZUR BEARBEITUNG VON WAFERN**
UNIT FOR PROCESSING WAFERS
DISPOSITIF DE TRAITEMENT DE PLAQUETTES

(30) Priorität: 29.10.1999 DE 19952194
(43) Veröffentlichungstag der Anmeldung: 24.07.2002
(73) Patentinhaber: Infineon Technologies AG, 81669 München (DE)
(72) Erfinder: ELGER, Jürgen, 90602 Pyrbaum (DE)
(74) Vertreter: Epping - Hermann - Fischer
(86) Internationale Anmeldenummer: PCT/DE2000/003742
(87) Internationale Veröffentlichungsnummer: WO 2001/033610

(56) Entgegenhaltungen:
- WO-A-99/49500
- DE-A- 19 745 386
- US-A- 4 672 185
- US-A- 5 266 812
- DATABASE WPI Section EI, Week 199951 Derwent Publications Ltd., London, GB; Class U11, AN 1999-596833 XP002165141 & JP 11 260883 A (DAINIPPON SCREEN SEIZO)
- PATENT ABSTRACTS OF JAPAN vol. 1995, no. 01, 28. Februar 1995 (1995-02-28) & JP 06 286824 A (SHARP CORP), 11. Oktober 1994 (1994-10-11)
- PATENT ABSTRACTS OF JAPAN vol. 1999, no. 03, 31. März 1999 (1999-03-31) & JP 10 321694 A (CANON INC), 4. Dezember 1998 (1998-12-04)

## Beschreibung

Die Erfindung betrifft eine Anlage zur Bearbeitung von Wafern mit mehreren Fertigungseinheiten und Messeinheiten sowie einem Transportsystem zum Transport der Wafer.

Derartige Anlagen umfassen eine Vielzahl von Fertigungseinheiten, mit welchen unterschiedliche Fertigungsprozesse durchgeführt werden. Bei diesen Fertigungsprozessen handelt es sich insbesondere um Ätzprozesse, Nasschemieverfahren, Diffusionsprozesse sowie diverse Reinigungsverfahren wie zum Beispiel CMP-Verfahren (Chemical Mechanical Polishing). Für jeden dieser Prozesse sind eine oder mehrere Fertigungseinheiten vorgesehen, in welchen verschiedene Fertigungsschritte eines Fertigungsprozesses durchgeführt werden.

Zudem umfassen derartige Anlagen eine Vielzahl von Messeinheiten. In den Messeinheiten wird die Bearbeitungsqualität von einem oder mehreren Fertigungsschritten eines Fertigungsprozesses überprüft.

Der gesamte Fertigungsprozess unterliegt strengen Reinheitsanforderungen, so dass die Fertigungseinheiten und Messeinheiten in einem Reinraum oder in einem System von Reinräumen angeordnet sind.

Die Wafer werden in als Kassetten ausgebildeten Behältern in vorbestimmten Losgrößen über ein Transportsystem den einzelnen Fertigungseinheiten zugeführt. Auch der Abtransport der Kassetten nach Bearbeitung dieser Wafer erfolgt über das Transportsystem.

Das Transportsystem weist typischerweise ein Fördersystem mit einer Anzahl von Förderern auf, welche beispielsweise in Form von Rollenförderern ausgebildet sind. Die Kassetten mit den Wafern werden dabei auf den Rollenförderern aufliegend transportiert. Alternativ kann das Fördersystem 5 auch aus Stetigförderern, Hängeförderern oder dergleichen bestehen.

Zur Steuerung derartiger Anlagen ist üblicherweise ein Materialdispositionssystem vorgesehen. Mittels dieses Materialdispositionssystems werden Wafer in bestimmter Anzahl aus einem Lager oder dergleichen ausgelagert und in Losen zusammengefasst. Für die einzelnen Lose werden Arbeitspläne erstellt, die die einzelnen Bearbeitungsschritte enthalten, welche mit den Wafern beim Durchlauf durch die Anlage in den einzelnen Fertigungseinheiten und Messeinheiten durchgeführt werden. Zudem erfolgt über das Materialdispositionssystem eine Vergabe von Prioritäten für die einzelnen Wafer. Anhand dieser Priorisierung ergibt sich eine bestimmte Bearbeitungsreihenfolge für die Wafer der unterschiedlichen Lose.

Schließlich werden die Wafer über das Materialdispositionssystem dem Transportsystem zugeführt, über welches die Zufuhr der Behälter mit den Wafern zu den einzelnen Fertigungseinheiten und Messeinheiten erfolgt. Dabei werden die Behälter im Transportsystem mit vorgegebenen losbezogenen Transportaufträgen eingelastet. Die Transportaufträge enthalten insbesondere die Zielorte für die einzelnen Behälter, wobei die Zielorte von Fertigungseinheiten und Messeinheiten gebildet sind.

Anhand dieser Transportaufträge werden die Behälter den einzelnen Zielorten zugeführt. Nur für den Fall, dass eine Fertigungs- oder Messeinheit außer Betrieb ist, wird eine Störungsmeldung an das Materialdispositionssystem ausgegeben, so dass eine weitere Zulieferung von Wafern unterbunden wird. Nachteilig hierbei ist jedoch, dass Transportaufträge auch dann noch an einzelne Fertigungs- und Messeinheiten erfolgen, wenn diese zwar noch funktionsfähig sind, aber bereits überlastet sind. In diesem Fall stauen sich die Wafer vor den betreffenden Fertigungs- und Messeinheiten. Durch die dabei auftretenden Wartezeiten bei der Bearbeitung der Wafer wird deren Durchlaufzeit durch die Anlage unerwünscht erhöht, wodurch insbesondere auch die Herstellkosten für die Wafer erhöht werden.

In der US-A-4 672 185 ist eine Anlage zur Bearbeitung von Wafern beschrieben, die mehrere Fertigungseinheiten aufweist sowie ein Transportsystem, um den Wafertransport abzuwickeln. Den Fertigungseinheiten ist jeweils ein Erfassungssystem zugeordnet, mit welchem die Zufuhr und die Abfuhr der Wafer an der jeweiligen Fertigungseinheit festgestellt wird, um die Belegung der Fertigungseinheit mit Wafern zu erfassen. In Abhängigkeit dieser Belegung wird eine Versorgungsanforderung oder Entsorgungsanforderung für die jeweilige Fertigungseinheit generiert.

In JP-A-11-260883 sowie Derwent Publications Limited, Woche 1999/51, London, GB, Klasse Ull, AN 1999-596833, XP002165141 ist eine Steuerung für den Lauf von Substraten in einer Produktionslinie beschrieben, bei der die Zahl der in einer Fertigungseinheit befindlichen Substrate kontrolliert wird, um eine Überlastung der Einheit zu vermeiden. Eine andere Kontrolleinheit um die Zufuhr von Wafern an eine Fertigungseinheit zu erfassen ist in Patent Abstracts of Japan, Band 1995, Nr. 1, 28. Februar 1995, JP-A-06-286824 beschrieben.

Der Erfindung liegt die Aufgabe zugrunde, eine Anlage der eingangs genannten Art so auszubilden, dass die Durchlaufzeiten der Wafer bei deren Bearbeitung in der Anlage möglichst gering sind.

Zur Lösung dieser Aufgabe sind die Merkmale des Anspruchs 1 vorgesehen. Vorteilhafte Ausführungsformen und zweckmäßige Weiterbildungen der Erfindung sind in den Unteransprüchen beschrieben.

Den Fertigungseinheiten und Messeinheiten der Anlage ist jeweils ein Erfassungssystem zugeordnet, mit welchem die Zufuhr und Abfuhr der Wafer an der jeweiligen Fertigungs- und Messeinheit zur Ermittlung deren Belegung mit Wafern erfassbar ist. In Abhängigkeit dieser Belegung ist eine Versorgungs- oder Entsorgungsanforderung für die jeweilige Fertigungs- oder Messeinheit generierbar.

Das Erfassungssystem umfasst eine Sensoranordnung, mit welchem die Wafer gezählt werden, die einer Fertigungseinheit oder Messeinheit zugeführt werden oder von dieser abgeführt werden. Besonders vorteilhaft können dabei gleichzeitig die einzelnen Wafer oder die Behälter, in welchen die Wafer transportiert werden, identifiziert werden. In Abhängigkeit der in dem Erfassungssystem erfassten Informationen werden vorzugsweise in einem Leitstand, der mit den einzelnen Fertigungs- und Messeinheiten gekoppelt ist, Versorgungs- und Erfassungsanforderungen für die einzelnen Fertigungs- und Messeinheiten generiert. Anhand der dadurch im Leitstand bekannten Kapazitätsauslastungen der einzelnen Fertigungs- und Messeinheiten können diesen über eine geeignete Wahl von Transportaufträgen Wafer in geeigneter Anzahl Zugeführt werden. Da vorzugsweise die Wafer in den Erfassungssystemen identifiziert werden können, kann die Zufuhr der einzelnen Wafer in den Fertigungseinheiten und Messeinheiten auch optimiert hinsichtlich der aktuellen Bearbeitungszustände erfolgen und entsprechend den in den Fertigungs- und Messeinheiten durchführbaren Bearbeitungsschritte.

Dadurch können Wartezeiten der Wafer vor den einzelnen Fertigungs- und Messeinheiten weitgehend vermieden und die Bearbeitungskapazitäten der Fertigungs und Messeinheiten optimal genutzt werden.

Besonders vorteilhaft ist, dass die Erfassungssysteme als Module ausgebildet sein können, die an bestehenden Fertigungs- und Messeinheiten nachgerüstet werden können.

Mit den bekannten im Einsatz befindlichen Fertigungs- und Messeinheiten können die dort verfügbaren Bearbeitungskapazitäten nicht erfasst werden. Zudem fehlen Schnittstellen, über welche derartige Informationen ausgegeben werden könnten. Um derartige Informationen verfügbar zu machen müssten die Fertigungs- und Messeinheit in wesentlichen Bereichen neu konzipiert werden, was zu umfangreichen konstruktiven Änderungen führen würde. Dies würde nicht nur erhebliche Investitionskosten verursachen, sondern wäre auch äußerst zeitaufwendig.

Mit den als Modulen ausgebildeten Erfassungssystemen kann jedoch der Funktionsumfang der Fertigungs- und Messeinheiten schnell und ohne hohen Kostenaufwand erweitert werden.

Die Erfindung wird im nachstehenden Ausführungsbeispiel anhand der Zeichnungen erläutert. Es zeigen:
- Figur 1:: Schematische Darstellung einer Anlage zur Bearbeitung von Wafern mit einer Anordnung von Bearbeitungsstationen.
- Figur 2:: Blockschaltbild von Komponenten zur Ablaufsteuerung der Anlage gemäß Figur 1.
- Figur 3:: Schematische Darstellung eines Erfassungssystems an einer Fertigungs- und Messeinheit der Anlage gemäß Figur 1.

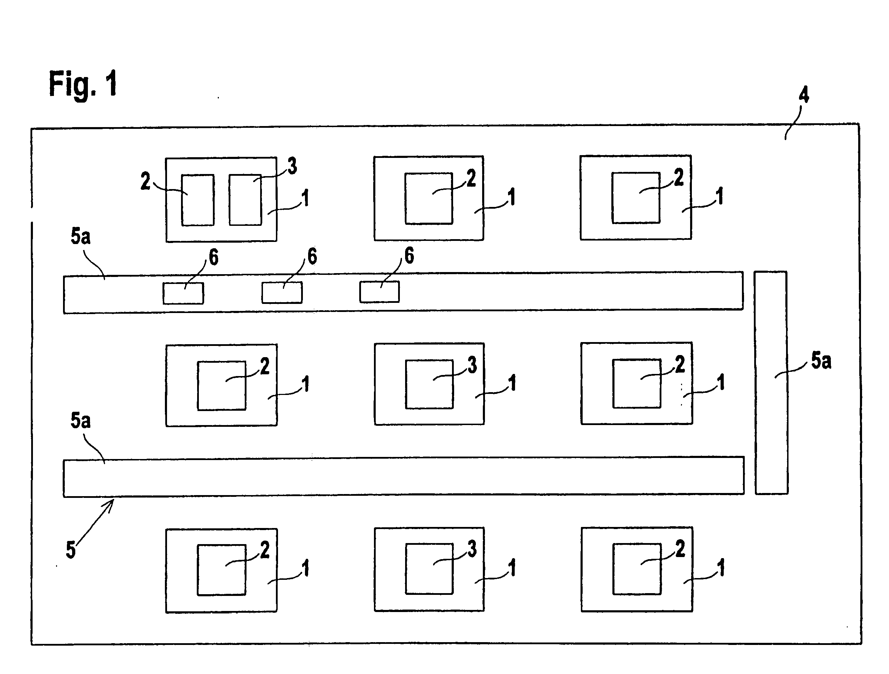

In Figur 1 ist schematisch eine Anlage zur Bearbeitung von Wafern dargestellt. Die Anlage weist eine Vielzahl von Bearbeitungsstationen 1 auf, wobei in einer Bearbeitungsstation 1 eine oder mehrere Fertigungseinheiten 2 oder Messeinheiten 3 vorgesehen sind.

Die Fertigungseinheiten 2 dienen zur Durchführung unterschiedlicher Fertigungsschritte bei den für die Bearbeitung der Wafer erforderlichen Fertigungsprozessen. Diese Fertigungsprozesse umfassen insbesondere Ätzprozesse, Nasschemieverfahren, Diffusionsprozesse sowie Reinigungsverfahren. Für die einzelnen Fertigungsprozesse können entsprechend der Anzahl der durchzuführenden Fertigungsschritte eine oder mehrere Fertigungseinheiten 2 vorgesehen sein.

Die Messeinheiten 3 dienen zur Überprüfung der Bearbeitungsqualität der in den einzelnen Fertigungseinheiten 2 durchgeführten Fertigungsschritte.

Die Bearbeitungsstationen 1 mit den einzelnen Fertigungseinheiten 2 und Messeinheiten 3 sind in einem Reinraum 4 angeordnet und über ein Transportsystem miteinander verbunden. Alternativ können die Bearbeitungsstationen 1 über ein System von Reinräumen 4 verteilt sein.

Das Transportsystem weist ein Fördersystem 5 mit mehreren Förderern 5a auf, welches die Wafer den einzelnen Bearbeitungsstationen 1 zuführt. Die Wafer werden dabei in Behältern 6 transportiert, welche vorzugsweise als Kassetten ausgebildet sind. Die Förderer 5a können in Form von Rollenförderern, Stetigförderern oder dergleichen ausgebildet sein. Zwischen den Förderern 5a können übergabestationen oder dergleichen zur Übergabe der Wafer vorgesehen sein. Das Transportsystem kann zudem ein nicht dargestelltes Speichersystem aufweisen, welches mehrere im Reinraum 4 verteilte Speicher umfasst. Diese Speicher können insbesondere als Stocker ausgebildet sein. In diesen Speichern werden Behälter 6 mit Wafern zwischengelagert. Beispielsweise können dort Behälter 6 zwischengelagert werden, welche Wafer enthalten, die in den einzelnen Fertigungseinheiten 2 fehlerhaft bearbeitet wurden. Zu geeigneten Zeitpunkten werden diese zur Nacharbeit aus den Speichern ausgelagert und bestimmten Fertigungseinheiten 2 zugeführt.

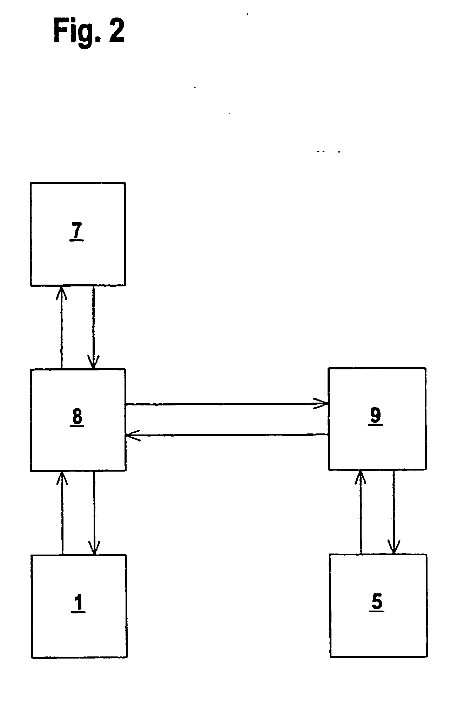

Figur 2 zeigt ein Blockschaltbild zur Ablaufsteuerung der Anlage zur Bearbeitung von Wafern. Ein zentrales Produktionsplanungs- und Steuerungssystem 7 ist an ein Leitsystem 8 angeschlossen. An das Leitsystem 8 sind die einzelnen Bearbeitungsstationen 1 mit den Fertigungseinheiten 2 und Messeinheiten 3 angeschlossen. An das Leitsystem 8 ist zudem eine Fördertechniksteuerung 9 angeschlossen, welche mit dem Fördersystem 5 des Transportsystems verbunden ist.

Die vorgenannten Komponenten der Anlage weisen jeweils wenigstens eine Rechnereinheit auf. Die Anschlüsse zwischen den einzelnen Komponenten sind jeweils als bidirektionale Datenleitungen zwischen den einzelnen Rechnereinheiten dieser Komponenten ausgebildet.

Das Produktionsplanungs- und Steuerungssystem 7 dient zur Kapazitätsermittlung und Bedarfsermittlung für die gesamte Anlage. Die Kapazitäten und Bedarfe zur Bearbeitung der Wafer in den einzelnen Fertigungs- 2 und Messeinheiten 3 werden für Zeiträume in der Größenordnung von einigen Tagen bis Wochen vorausgeplant. Anhand dieser Planung erfolgt eine Zuordnung von bestimmten Bearbeitungsschritten für Fertigungseinheiten 2 und Messeinheiten 3, die hierfür besonders geeignet sind.

Zudem werden in dem Produktionsplanungs- und Steuerungssystem 7 Fertigungsaufträge und Arbeitspläne für die Bearbeitung der Wafer generiert.

In dem Leitsystem 8 werden zu Beginn des Bearbeitungsprozesses mehrere Wafer zu Losen zusammengefasst, wobei die Wafer eines Loses in einem Behälter 6 untergebracht werden. Hierzu werden die entsprechenden Wafer über das Leitsystem 8 aus einem Lager ausgelagert und manuell oder maschinell in Behältern 6 untergebracht.

Von dem Produktionsplanungs- und Steuerungssystem 7 werden in das Leitsystem 8 die einzelnen Arbeitspläne und Fertigungsaufträge eingelesen, abgespeichert und verwaltet. Aus den Arbeitsplänen und Fertigungsaufträgen werden von dem Leitsystem 8 Parametersätze zur Definition der Bearbeitungsschritte, die in den einzelnen Fertigungseinheiten 2 und Messeinheiten 3 durchgeführt werden sollen, generiert und in diese eingelesen. Schließlich wird im Leitsystem 8 geprüft, ob der für die einzelnen Wafer jeweils nächste Bearbeitungsschritt in der hierfür vorgesehenen Fertigungs- 2 und Messeinheit 3 durchführbar ist.

Zudem erfolgt anhand der Daten im Leitsystem 8 eine Priorisierung für die Bearbeitung der einzelnen Wafer oder Lose, wobei diese Planung typischerweise innerhalb eines Zeithorizonts von einigen Minuten bis Stunden variiert. Die Priorisierung der Wafer ist dabei insbesondere abhängig von deren Bearbeitungszuständen.

Das Fördersystem 5 der Anlage wird durch die Fördertechniksteuerung 9 nach Vorgaben des Leitsystems 8 gesteuert. Die Fördertechniksteuerung 9 weist hierzu zur Steuerung der Antriebselemente des Fördersystems 5 eine Anzahl von Motoren und Gebern auf.

Den Fertigungs- 2 und Messeinheiten 3 ist jeweils ein Erfassungssystem zugeordnet, mittels dessen die Zufuhr und Abfuhr der Wafer an der jeweiligen Fertigungs- 2 oder Messeinheit 3 erfassbar ist. Aus diesen Daten werden die Belegungen der einzelnen Fertigungseinheiten 2 und Messeinheiten 3 mit Wafern ermittelt. In dem Leitsystem 8, an welchem die Fertigungseinheiten 2 und Messeinheiten 3 angeschlossen sind, werden aus den Belegungen dieser Einheiten Versorgungs- und Entsorgungsanforderungen generiert. Anhand dieser Versorgungs- und Entsorgungsanforderungen werden im Leitsystem 8 Transportaufträge im Transportsystem eingelastet, um die Wafer entsprechend dieser Anforderungen den Fertigungs- 2 und Messeinheiten 3 in geeigneter Anzahl zuzuführen oder diese abzutransportieren.

Zudem können prinzipiell auch den Speichern des Speichersystems derartige Erfassungssysteme zugeordnet sein.

Im vorliegenden Ausführungsbeispiel bestehen die Erfassungssysteme aus Modulen, welche an den Fertigungs- 2 und Messeinheiten 3 angebracht werden können, ohne deren Funktionsumfang ändern zu müssen. Die Module können daher den bestehenden Fertigungs- 2 und Messeinheiten 3 auf einfache Weise nachgerüstet werden.

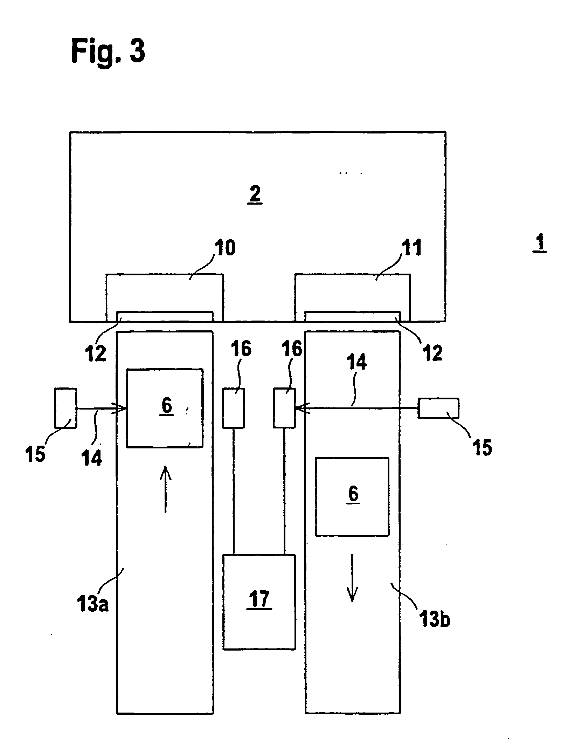

Figur 3 zeigt eine Bearbeitungsstation 1 mit einer Fertigungseinheit 2. Die Zufuhr und Abfuhr von Wafern erfolgt über eine Be- und Entladestation. Diese weist einen Belade-Port 10 für die Zufuhr von Wafern zur Fertigungseinheit 2 sowie einen Entlade-Port 11 zum Abtransport der Wafer auf. Der Belade-Port 10 und der Entlade-Port 11 weisen jeweils eine Bearbeitungsklappe 12 auf. Durch Öffnen der Bearbeitungsklappen 12 werden die Behälter 6 mit Wafern über die Öffnung des Belade-Ports 10 in die Fertigungseinheit 2 eingeführt und über die Öffnung des Entlade-Ports 11 aus der Fertigungseinheit 2 ausgeschleust.

Die Be- und Entladestation weist zudem zwei Förderer 13a, 13b auf. Über den ersten Förderer 13a werden die Behälter 6 mit Wafern dem Belade-Port 10 zugeführt. Mit dem Förderer 13b werden die am Entlade-Port 11 ausgeschleusten Behälter 6 abtransportiert.

Das Erfassungssystem weist eine Sensoranordnung zur Erfassung der Anzahl von Wafern auf, die über die Be- und Entladestation geführt werden. In Figur 3 besteht die Sensoranordnung aus Optosensoren, welche als Lichtschranken ausgebildet sind.

Die Lichtschranken weisen jeweils einen Sendelichtstrahlen 14 emittierenden Sender 15 und einen Empfänger 16 auf, der die Sendelichtstrahlen 14 empfängt. Die Detektion von Objekten erfolgt durch eine Unterbrechung des Strahlengangs der Sendelichtstrahlen 14.

Gemäß einem Ausführungsbeispiel der Erfindung wird ein Erfassungssystem vorgesehen, bei dem die Behälter 6 dadurch gezählt werden, dass mit den Lichtschranken das Öffnen und Schließen der Bearbeitüngsklappen 12 fortlaufend registriert wird.

Gemäß Figur 3 ist jeweils eine Lichtschranke an einen der Förderer 13a, 13b der Be- und Entladestation angebracht, so dass die auf den Förderern 13a, 13b transportierten Behälter 6 mit den Lichtschranken separat gezählt werden.

Die Lichtschrankensignale werden über eine Auswerteeinheit 17 gezählt. Die Zählimpulse können dann in dem Leitsystem 8 ausgewertet werden, um die Belegung der Fertigungseinheit 2 mit Wafern zu ermitteln, woraus dann die Versorgungs- und Entsorgungsaufforderungen generiert werden.

Alternativ kann in der Auswerteeinheit die Belegung der Fertigungseinheit 2 ermittelt werden und dann in das Leitsystem 8 eingelesen werden.

In einem Beispiel, das nicht Teil der Erfindung ist, kann das Erfassungssystem ohne Sensoranordnung ausgebildet sein. Beispielsweise kann zum Zählen der zu- und abgehenden Behälter 6 in der Fertigungseinheit 2 über Abgreifen geeigneter Digitalsignale an der Fertigungseinheit 2 das Betätigen der Bearbeitungsklappen 12 an dem Belade- 10 und Entlade-Port 11 erfasst werden.

Alternativ, und auch nicht Teil der Erfindung, kann das Erfassungssystem zum Zählen der Behälter 6 auch eine Aktuatoranordnung aufweisen. Die Aktuatoren können beispielsweise von mechanischen Schaltern oder dergleichen gebildet sein.

Prinzipiell können die vorgenannten Aktuator- oder Sensoranordnungen auch dazu verwendet werden, einzelne Wafer zu zählen, welche den Fertigungs- 2 und Messeinheiten 3 zugeführt und von diesen abtransportiert werden.

In einer besonders vorteilhaften Ausführungsform weisen die Erfassungssysteme jeweils auch Mittel zur Identifikation der Wafer oder der Behälter 6, in welchen diese transportiert werden, auf. Die Wafer und/oder Behälter 6 sind hierzu zweckmäßigerweise jeweils mit Barcodes gekennzeichnet.

Die Wafer und/oder die Behälter 6 werden dann mittels Barcodelesegeräten identifiziert, die vorzugsweise an den Be- und Entladestationen der Fertigungs- 2 und Messeinheiten 3 angeordnet sind.

Besonders vorteilhaft bilden diese Barcodelesegeräte nicht nur die Mittel zur Identifikation der Wafer und/oder Behälter 6 sondern bilden gleichzeitig auch die Sensoranordnungen, mit welchen die Anzahl der an der jeweiligen Fertigungs- 2 oder Messeinheit 3 zu- und abgehenden Wafern und/oder Behälter 6 erfasst wird.

In diesem Fall können von den Erfassungssystemen nicht nur die Anzahl der zu- und abgehenden Wafer an einer Fertigungs-2 und Messeinheit 3 an das Leitsystem 8 gemeldet werden. Vielmehr kann auch erfasst werden, welche Wafer sich in welchem Bearbeitungsstadium an einer bestimmten Fertigungs- 2 und Messeinheit 3 befinden.

Anhand dieser Informationen können in dem Leitsystem 8 die Versorgungs- und Entsorgungsanforderungen auf die jeweiligen Bearbeitungszustände der Wafer genau zugeschnitten werden.

Typischerweise weisen die Fertigungs- 2 und Messeinheiten 3 der Anlage jeweils eine vorgegebene Anzahl von Kammern auf. Zweckmäßigerweise wird über das Erfassungssystem erfasst, welche Wafer den einzelnen Kammern zugewiesen werden. Hierbei ist insbesondere eine Identifikation der Wafer über das Erfassungssystem zweckmäßig. Die Versorgungs- und Entsorgungsanforderungen werden dann im Leitsystem 8 für die einzelnen Kammern der Fertigungs- 2 und Messeinheiten 3 generiert.

## Patentansprüche

1. Anlage zur Bearbeitung von Wafern mit mehreren Fertigungseinheiten (2) und Messeinheiten (3) sowie einem Transportsystem (5,5a,6) zum Transport der Wafer, bei der
- den Fertigungseinheiten (2) und Messeinheiten (3) jeweils ein Erfassungssystem zugeordnet ist, mit welchen die Zufuhr und Abfuhr der Wafer an der jeweiligen Fertigungs- (2) oder Messeinheit (3) zur Ermittlung deren Belegung mit Wafern erfassbar ist, und in Abhängigkeit dieser Belegung eine Versorgungsanforderung oder Entsorgungsanforderung für die jeweilige Fertigungs- (2) und Messeinheit (3) generierbar ist,
- die Fertigungs- (2) und Messeinheiten (3) jeweils eine Be- und Entladestation aufweisen, welche wenigstens einen mit einer ersten Bearbeitungsklappe (12) verschließbaren Belade-Port (10) für die Zufuhr der Wafer und wenigstens einen mit einer Bearbeitungsklappe (12) verschließbaren Entlade-Port (11) für die Abfuhr der Wafer aufweisen, und
- das Erfassungssystem eine Sensoranordnung aufweist, mit der zur Erfassung der Anzahl der Wafer, die der jeweiligen Fertigungs- (2) oder Messeinheit (3) zugeführt und von dieser abgeführt werden, das Betätigen der Bearbeitungsklappen (12) der Belade-Ports (10) und Entlade-Ports (11) erfassbar ist.

2. Anlage nach Anspruch 1, **dadurch gekennzeichnet, dass** die Anlage so gestaltet ist, dass die Wafer in Behältern (6) den Fertigungs- (2) und Messeinheiten (3) zugeführt und in Behältern (6) von diesen abgeführt werden.

3. Anlage nach Anspruch 1 oder 2, **dadurch gekennzeichnet, dass** die Wafer auf einzelnen Förderern (13a, 13b) zu den einzelnen Belade-Ports (10) zugeführt und auf einzelnen Förderern (13a, 13b) von den einzelnen Entlade-Ports (11) abgeführt werden.

4. Anlage nach Anspruch 3, **dadurch gekennzeichnet, dass** mittels der Sensoranordnung die Wafer oder Behälter (6) auf den Förderern (13a, 13b) erfassbar sind.

5. Anlage nach einem der vorigen Ansprüche, **dadurch gekennzeichnet, dass** die Sensoranordnung eine Anzahl von Optosensoren aufweist.

6. Anlage nach Anspruch 5, **dadurch gekennzeichnet, dass** die Optosensoren von Lichtschranken, Lichttastern und/oder Barcodelesegeräten gebildet sind.

7. Anlage nach einem der vorigen Ansprüche, **dadurch gekennzeichnet, dass** die Erfassungssysteme an ein Leitsystem (8) angeschlossen sind, in welchem die Versorgungs- und Entsorgungsanforderungen für die jeweilige Fertigungs- (2) oder Messeinheit (3) generiert werden.

8. Anlage nach Anspruch 7, **dadurch gekennzeichnet, dass** von den Erfassungssystemen die Anzahl der zugeführten und abgeführten Wafer in das Leitsystem (8) eingelesen werden, und dass anhand dessen in dem Leitsystem (8) die Belegungen der einzelnen Fertigungs- (2) und Messeinheiten (3) mit Wafern bestimmt werden.

9. Anlage nach Anspruch 7, **dadurch gekennzeichnet, dass** die Erfassungssysteme jeweils eine Auswerteeinheit (17) aufweisen, in welcher aus der Anzahl der zugeführten Wafer und aus der Anzahl der abgeführten Wafer die Belegungen der jeweiligen Fertigungs- (2) oder Messeinheit (3) ermittelt werden, und dass die Belegungen der Fertigungs- (2) und Messeinheiten (3) in das Leitsystem (8) eingelesen werden.

10. Anlage nach einem der vorigen Ansprüche, **dadurch gekennzeichnet, dass** das Erfassungssystem Mittel zur Identifikation der Wafer aufweist.

11. Anlage nach Anspruch 10, **dadurch gekennzeichnet, dass** die Wafer und/oder Behälter (6) mit Wafern mit Barcodes **gekennzeichnet** sind, und dass die Mittel zur Identifikation der Wafer von Barcodelesegeräten gebildet sind.

12. Anlage nach einem der Ansprüche 10 bis 11, **dadurch gekennzeichnet, dass** die Fertigungs- (2) und Messeinheiten (3) jeweils mehrere Kammern aufweisen, und dass mittels des Erfassungssystems erfasst wird, welche und wie viele Wafer den einzelnen Kammern zugewiesen sind.

13. Anlage nach Anspruch 12, **dadurch gekennzeichnet, dass** in einem Leitsystem (8) die versorgungs- und Entsorgungsanforderungen für die einzelnen Kammern der Fertigungs- (2) und Messeinheiten (3) generiert werden.

14. Anlage nach einem der Ansprüche 10 bis 13, **dadurch gekennzeichnet, dass** in einem Leitsystem (8) geprüft wird ob für Wafer in einem Behälter (6) der jeweils folgende Bearbeitungsschritt in der jeweiligen Fertigungs- (2) oder Messeinheit (3) durchführbar ist.

15. Anlage nach einem der Ansprüche 10 bis 14, **dadurch gekennzeichnet, dass** von einem Leitsystem (8) in die angeschlossenen Fertigungs- (2) und Messeinheiten (3) jeweils Parametersätze zur Definition der Bearbeitungsschritte, die dort mit Wafern bestimmter Lose durchgeführt werden, eingelesen werden.

16. Anlage nach einem der vorigen Ansprüche, **dadurch gekennzeichnet , dass** diese ein Speichersystem mit mehreren Speichern aufweist, an welchen Erfassungssysteme zur Erfassung deren Belegung mit Wafern angeordnet sind.

17. Anlage nach einem der vorigen Ansprüche, **dadurch gekennzeichnet, dass** das Erfassungssystem in Form eines an den Fertigungs- (2) und Messeinheiten (3) nachrüstbaren Moduls ausgebildet ist.

## Claims

1. Plant for processing wafers, having a plurality of fabrication units (2) and measuring units (3) and a transport system (5, 5a, 6) for transporting the wafers, in which
- the fabrication units (2) and measuring units (3) are each assigned a registration system, with which the feed and discharge of the wafers to and from the respective fabrication unit (2) or measuring unit (3) can be registered in order to determine their occupancy by wafers, and, depending on this occupancy, a supply request or disposal request can be generated for the respective fabrication unit (2) and measuring unit (3),
- the fabrication units (2) and measuring units (3) each have a loading and unloading station, which have at least one loading port (10), which can be closed by a first processing flap (12), for feeding the wafers and at least one unloading port (11), which can be closed by a processing flap (12), for discharging the wafers, and
- the registration system has a sensor arrangement with which the actuation of the processing flaps (12) of the loading ports (10) and unloading ports (11) can be registered in order to register the number of wafers which are fed to the respective fabrication unit (2) or measuring unit (3) and discharged from the latter.

2. Plant according to Claim 1, **characterized in that** the plant is configured such that the wafers are fed to the fabrication units (2) and measuring units (3) in containers (6) and are discharged from said units in containers (6).

3. Plant according to Claim 1 or 2, **characterized in that** the wafers are fed to the individual loading ports (10) on individual conveyors (13a, 13b), and are discharged from the individual unloading ports (11) on individual conveyors (13a, 13b).

4. Plant according to Claim 3, **characterized in that** by means of the sensor arrangement, the wafers or containers (6) on the conveyors (13a, 13b) can be registered.

5. Plant according to one of the preceding claims, **characterized in that** the sensor arrangement has a number of optical sensors.

6. Plant according to Claim 5, **characterized in that** the optical sensors are formed by light barriers, light sensors and/or bar-code readers.

7. Plant according to one of the preceding claims, **characterized in that** the registration systems are connected to a process control system (8), in which the supply and disposal requests for the respective fabrication unit (2) or measuring unit (3) are generated.

8. Plant according to Claim 7, **characterized in that** the number of wafers fed and discharged is read into the process control system (8) from the registration systems, and **in that** on this basis, the occupancies of the individual fabrication units (2) and measuring units (3) by wafers are determined in the process control system (8).

9. Plant according to Claim 7, **characterized in that** the registration systems each have an evaluation unit (17), in which the number of wafers fed in and the number of wafers discharged are used to determine the occupancies of the respective fabrication unit (2) or measuring unit (3), and **in that** the occupancies of the fabrication units (2) and measuring units (3) are read into the process control system (8).

10. Plant according to one of the preceding claims, **characterized in that** the registration system has means of identifying the wafers.

11. Plant according to Claim 10, **characterized in that** the wafers and/or containers (6) with wafers are identified by bar codes, and **in that** the means of identifying the wafers are formed by bar-code readers.

12. Plant according to one of Claims 10 to 11, **characterized in that** the fabrication units (2) and measuring units (3) in each case have a plurality of chambers, and **in that** the registration system is used to register which and how many wafers are allocated to the individual chambers.

13. Plant according to Claim 12, **characterized in that** the supply and disposal requests for the individual chambers of the fabrication units (2) and measuring units (3) are generated in a process control system (8).

14. Plant according to one of Claims 10 to 13, **characterized in that** in a process control system (8), a check is made as to whether the respectively following processing step for wafers in a container (6) can be carried out in the respective fabrication unit (2) or measuring unit (3).

15. Plant according to one of Claims 10 to 14, **characterized in that** from a process control system (8), in each case parameter sets for the definition of the processing steps which are carried out there with wafers of a specific batch are read into the connected fabrication units (2) and measuring units (3).

16. Plant according to one of the preceding claims, **characterized in that** said plant has a storage system having a plurality of stores, on which registration systems are arranged to register their occupancy with wafers.

17. Plant according to one of the preceding claims, **characterized in that** the registration system is designed in the form of a module that can be retrofitted to the fabrication units (2) and measuring units (3).

## Revendications

1. Installation de traitement de plaquettes comprenant plusieurs unités (2) de fabrication et unités (3) de mesure, ainsi qu'un système (5, 5a, 6) de transport des plaquettes, dans laquelle
- il est affecté aux unités (2) de fabrication et aux unités (3) de mesure, respectivement, un système de détection par lequel l'apport et l'évacuation des plaquettes à l'unité (2) de fabrication ou à l'unité (3) de mesure respective peuvent être détectés pour déterminer leur occupation par des plaquettes, et en fonction de cette occupation, une demande d'alimentation ou une demande d'évacuation de l'unité (2) de fabrication et de l'unité (3) de mesure respectives peut être engendrée,
- les unités (2) de fabrication et les unités (3) de mesure ont respectivement un poste de chargement et de déchargement, qui a au moins un accès (10) de chargement pouvant être fermé par un premier volet (12) de traitement pour l'apport des tranches et au moins un accès (11) de déchargement qui peut être fermé par un volet (12) de traitement pour l'évacuation des plaquettes, et
- le système de détection a un dispositif à capteur par lequel il peut être, pour la détection du nombre des plaquettes qui sont apportées à l'unité (2) de fabrication ou à l'unité (3) de mesure respectives ou qui peut en être évacué, détecté l'actionnement du volet (12) de traitement de l'accès (10) de chargement et de l'accès (11) de déchargement.

2. Installation suivant la revendication 1, **caractérisée en ce qu'**elle est telle que les plaquettes sont apportées dans des récipients (6) aux unités (2) de fabrication et aux unités (3) de mesure et en sont évacuées dans des récipients (6).

3. Installation suivant la revendication 1 ou 2, **caractérisée en ce que** les plaquettes sont apportées sur des convoyeurs (13a, 13b) individuels aux divers accès (10) de chargement et sont évacuées sur des transporteurs (13a, 13b) individuels des divers accès (11) de déchargement.

4. Installation suivant la revendication 3, **caractérisée en ce que** les plaquettes ou les récipients (6) peuvent être détectés sur les convoyeurs (13a, 13b) au moyen du dispositif à capteur.

5. Installation suivant l'une des revendications précédentes, **caractérisée en ce que** le dispositif à capteur a un certain nombre d'optocapteurs.

6. Installation suivant la revendication 5, **caractérisée en ce que** les optocapteurs sont formés par des cellules photoélectriques, par des détecteurs à spots mobiles et/ou par des appareils de lecture de codes barres.

7. Installation suivant l'une des revendications précédentes, **caractérisée en ce que** les systèmes de détection sont raccordés à un système (8) de pilotage dans lequel les demandes d'alimentation et d'évacuation de l'unité (2) de fabrication ou de l'unité (3) de mesure respectives sont engendrées.

8. Installation suivant la revendication 7,
**caractérisée en ce qu'**il est lu par les systèmes de détection, dans le système (8) de pilotage, le nombre des plaquettes apportées et évacuées, et **en ce qu'**au moyen de celui-ci, il est déterminé, dans le système (8) de pilotage, les occupations des diverses unités (2) de fabrication et unités (3) de mesure par des plaquettes.

9. Installation suivant la revendication 7, **caractérisée en ce que** les systèmes de détection ont respectivement une unité (17) d'exploitation dans laquelle on détermine, à partir du nombre des plaquettes apportées et à partir du nombre des plaquettes évacuées, les occupations de l'unité (2) de fabrication ou de l'unité (3) de mesure respectives, et **en ce qu'**on lit, dans le système (8) de pilotage, les occupations des unités (2) de fabrication et des unités (3) de mesure.

10. Installation suivant l'une des revendications précédentes, **caractérisée en ce que** le système de détection a des moyens d'identification des plaquettes.

11. Installation suivant la revendication 10, **caractérisée en ce que** les plaquettes et/ou les récipients (6) ayant des plaquettes sont **caractérisés par** des codes barres, et en ce que les moyens d'identification des plaquettes sont formés par des appareils de lecture de codes barres.

12. Installation suivant l'une des revendications 10 à 11, **caractérisée en ce que** les unités (2) de fabrication et les unités (3) de mesure ont respectivement plusieurs chambres, et **en ce qu'**il est détecté, au moyen du système de détection, quelles plaquettes et combien de plaquettes sont affectées aux diverses chambres.

13. Installation suivant la revendication 12, **caractérisée en ce qu'**il est engendré, dans un système (8) de pilotage, les demandes d'alimentation et d'évacuation des diverses chambres des unités (2) de fabrication et des unités (3) de mesure.

14. Installation suivant l'une des revendications 10 à 13, **caractérisée en ce qu'**il est contrôlé, dans un système (8) de pilotage, si, pour des plaquettes dans un récipient (6), le stade de traitement respectivement suivant peut être effectué dans l'unité (2) de fabrication ou dans l'unité (3) de mesure respectives.

15. Installation suivant l'une des revendications 10 à 14, **caractérisée en ce qu'**il est lu par le système (8) de pilotage, dans les unités (2) de fabrication et les unités (3) de mesure raccordées, respectivement, des jeux de paramètres de définitions des stades de traitement qui y sont effectués avec des plaquettes d'une mobilité déterminée.

16. Installation suivant l'une des revendications précédentes, **caractérisée en ce qu'**elle a un système à plusieurs réservoirs sur lesquels sont disposés des systèmes de détection de leur occupation par des plaquettes.

17. Installation suivant l'une des revendications précédentes, **caractérisée en ce que** le système de détection est sous la forme d'un module pouvant équiper après-coup les unités (2) de fabrication et les unités (3) de mesure.
